# EUROPEAN PATENT SPECIFICATION

(11) **EP 0 250 296 B1**
(45) Date of publication and mention of the grant of the patent: **09.02.1994**
(21) Application number: 87401304.8
(22) Date of filing: 11.06.1987
(51) Int. Cl.: H01L 21/00

(54) **Apparatus and method for tape bonding**
Vorrichtung und Verfahren zum Bandlöten
Dispositif et procédé de soudage de bande

(30) Priority: 19.06.1986 US 876317
(43) Date of publication of application: 23.12.1987
(73) Proprietor: FAIRCHILD SEMICONDUCTOR CORPORATION, Cupertino, California 95014 (US)
(72) Inventor: Drummond, Fred, San Jose California 95125 (US); Clark, James W., San Jose California 95111 (US)
(74) Representative: Sparing Röhl Henseler Patentanwälte

(56) References cited:
- DE-A- 3 144 048
- FR-A- 2 439 322
- FR-A- 2 496 519
- US-A- 4 342 151

## Description

The present invention relates generally to semiconductor assembly and packaging operations, and more particularly to apparatus and methods for tape automated bonding of semiconductor dies to lead frames and other substrates.

Improperly formed electrical connections are recognized as a dominant cause for failure of semiconductor device packages. Integrated circuit devices may include dozens, or even hundreds, of bonding pads which must be interconnected with other devices, typically by attachment to lead frames or specialized substrates. Such interconnection may be achieved by wire bonding, where small individual wires are bonded at one end to the bonding pad on the device, and at the other end to the lead frame or substrate. Alternatively, and of particular interest to the present invention, tape bonding utilizes gold or tin plated copper leads formed on a plastic tape. The leads are first bonded to the bonding pads on the semiconductor device in a single or "gang" operation. Thereafter, the semiconductor device is carried on the tape to a second location where the outer ends of the leads are bonded to a package lead frame or other substrate, also in a single operation.

Bonding of metal tape can be achieved either by thermocompression of gold-plated tape, reflow of solder-plated tape, or eutectic bonding of tin-plated tape. Of the three techniques, eutectic bonding is often preferred because it provides very reliable, low resistance contacts which are less prone to failure than contacts formed by the other two techniques. Such eutectic bonds, however, are generally more difficult to form and require much better temperature control of the bonding tool. A particular problem has arisen with certain bonding tools which are not evenly heated across the entire contact area. It has been found by the inventors herein that temperature variations on the order of ± 10C° can result in failure to achieve eutectic bonding regardless of adjustments made to the time period of contact.

For these reasons, it would be desirable to provide bonding tools which are specifically designed for forming eutectic bonds between bonding tape leads and metal bonding pads on semiconductor devices. In particular, it would be desirable if such bonding tools were capable of maintaining a precisely controlled temperature along the entire contact area, and which further allow a rapid heat-up and cool-down to allow for short cycling time. Finally, it would be desirable if the bonding tool were easy to manufacture and allowed for very close tolerances such as those found in very large scale integrated (VLSI) circuits where the individual dies have a very large number of closely spaced bonding pads.

Document FR-A-2 439 322 discloses a bonding apparatus comprising two electric power buses mounted on an electrically insulating support. Two linear resistance heating elements are connected to the buses via common joints. Where the linear elements are connected to the joints a restriction is provided so as to minimize heat dissipation from the heating elements towards the joints, in an attempt to assure uniform heating of the heating elements along their length.

Document FR-A-2 496 519 discloses a bonding apparatus which exhibits the features enumerated in the pre-characterizing part of patent claim 1.

The present invention is defined by the appending patent claim 1. The subclaims depending upon claim 1 define further aspects of the invention.

### BRIEF DESCRIPTION OF THE DRAWINGS

Fig. 1 is a side elevational view of the bonding apparatus of the present invention.

Fig. 2 is a top view of the bonding apparatus.

Fig. 3 is a front elevational view of the bonding apparatus.

Fig. 4 is a bottom view of the bonding apparatus.

Fig. 5 is a sectional view of the bonding apparatus taken along line 5-5 of Fig. 3.

Fig. 6 is an isometric view of the bonding apparatus with one of four power buses removed and a pair of linear heating elements moved away.

Fig. 7A and 7B are a side elevational and top view, respectively, of a first embodiment of the linear heating element of the present invention.

Figs. 8A, 8B, and 8C, are front, top, and side views, respectively, of a second embodiment of the linear heating element of the present invention.

Fig. 9 is a schematic illustration of the bonding system of the present invention.

Figs. 10A - 10C illustrate the steps in the bonding method of the present invention.

### DESCRIPTION OF THE PREFERRED EMBODIMENTS

According to the present invention, a bonding apparatus is provided for interconnecting tape leads between semiconductor dies and lead frames or other substrates. The bonding apparatus is suitable for forming both inner lead bonds (ILB), i.e., bonds between one end of the tape lead and the bonding pad on the semiconductor die, and outer lead bonds (OLB), i.e., bonds between the other end of the tape leads and the lead frame or substrate. The bonding apparatus is particularly intended for forming eutectic bonds where an alloy is formed between the material of the bonding pad, typically gold, and a material coated on the tape leads, typically tin. The formation of the gold-tin eutectic requires precise temperature control, and the bonding apparatus of the present invention is able to provide such control simultaneously for all bonds which are being formed. Although particularly intended for eutectic bonding, the present invention is also suitable for forming both conventional solder bonds where solder material coated on the tape is reflowed on the bonding pads and thermocompression bonds.

The present invention will employ conventional bonding tape, typically formed by etching or stamping a desired pattern of copper leads on a plastic, usually polyimide, carrier film. The copper leads are then plated with a coating material, typically tin for eutectic bonding or a tin-lead solder for conventional solder reflow bonding.

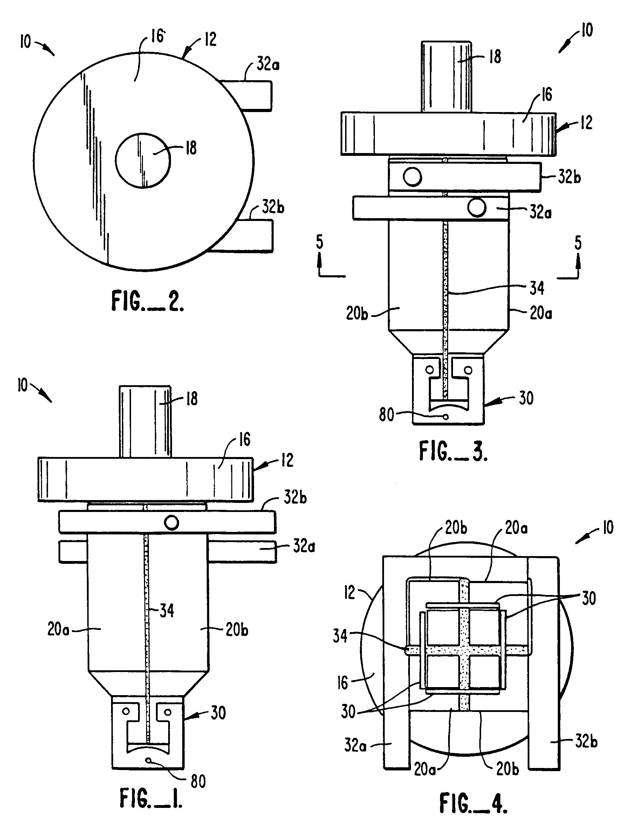

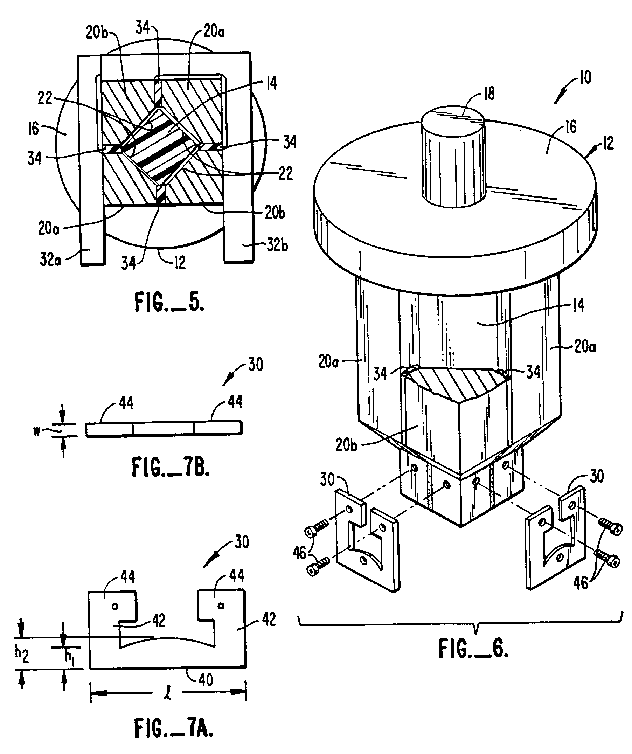

Referring now to Figs. 1-6, a bonding apparatus 10 includes a frame 12 comprising a square core 14 (Figs. 5 and 6) having a flange 16 and an extension 18. The frame 12 is formed from an electrically and thermally insulating material, typically an organic polymer such as a molded phenolic resin. The frame 12 will typically be molded as an integral unit, although the various pieces could be formed separately and assembled.

Four electric power bus members 20 are mounted about the periphery of the frame core 14, as best illustrated in Fig. 5. Each of the buses 20 is generally rectangular, having a square cross-section which is chamfered at one corner. The chamfered face 22 mates against a flat surface of the core 14 so that the power buses 20 are arranged generally parallel to the axis of the frame 12.

Four linear heating elements 30 are attached to the lower ends of the electric buses 20 with each element being electrically coupled to two adjacent buses. A first pair of diagonally-opposed buses 20a are electrically coupled to a first L-shaped connector 32a, while the second pair of diagonally-opposed buses 20b are electrically coupled to a second L-shaped connector 32b. The first L-shaped connector 32a is electrically isolated from the second pair of buses 20b and, similarly, the second L-shaped connector 32b is isolated from the first pair of buses 20b. In this way, by connecting the L-shaped connectors 32 to the opposite poles of a power source, substantially identical voltages are applied across the diagonally-opposed electric buses 20a and 20b. Since the heating elements 30 are electrically coupled to adjacent pairs of buses 20a/20b, identical voltages will be applied across each heating element, providing for a desired current flow and heating of the element.

The electric buses 20 are, of course, electrically isolated from one another by the core 14. Additionally, isolation pads 34 will normally be provided between adjacent buses to further assure isolation.

Referring now to Figs. 7A and 7B, the linear heating element 30 includes a rail 40 extending between a pair of legs 42. The legs 42 include contact portions 44 which are secured against the lower ends of the buses 20, typically by screws 46 (Fig. 6). The legs 42 serve to offset the rail 40 beneath the lower ends of the power buses 20. In this way, a circuit is completed between the positive and negative power buses 20a and 20b passing through the legs 42 and rail 40.

The linear heating elements 30 are specially formed to provide for even heating along the entire length ℓ of the rail 40. It is observed that unless the heating elements 30 are properly designed, the central portion of the heating element 40 will tend to heat more rapidly and reach a higher temperature than the portions near the legs 44. In order to compensate for this heating pattern, the mass of the rail 40 is concentrated near the middle. This distribution of the mass has several effects. First, the electrical resistance near the middle is reduced, lessening the amount of heat generated. Second, the area is increased, enhancing the heat dissipation from the central portion of the rail. Finally, the increased mass has a greater thermal lag, tending to increase the time required to heat and to lower the ultimate temperature reached. By properly selecting the mass distribution along the length of the rail 40, a substantially even heating pattern can be achieved for the elements 30. In the preferred embodiment of Fig. 7A and 7B, the rail 40 has a substantially even width W, with a variable height h along its length. The initial height h₁ proximate each of the legs 42 increases to a maximum of h₂ at the middle of the rail 40. The height ratio h₂/h₁ will depend on the length ℓ of the rail 40, but will usually vary between about 1.2 and 1.8, typically being about 1.5.

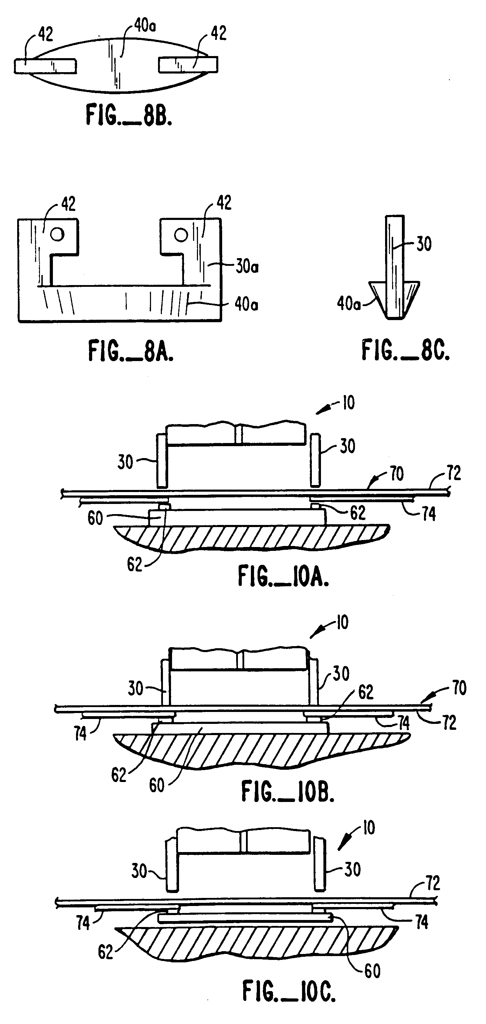

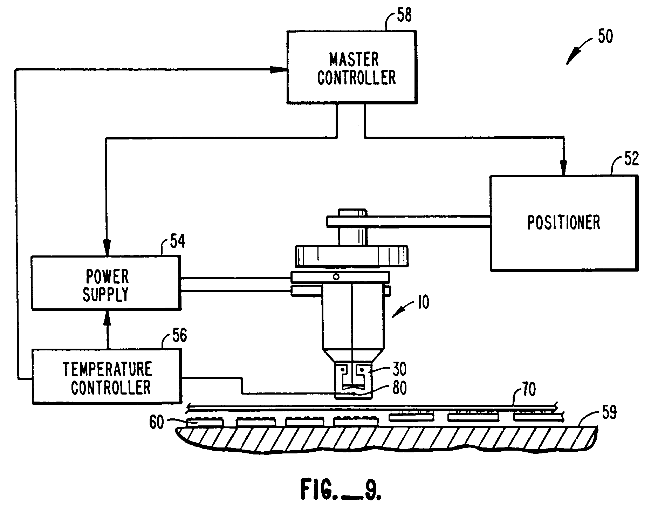

The exact shape of the heating element 30 is not critical, rather it is important only that the mass be properly distributed along the length in order to compensate for the inherently uneven heating characteristics in the linear heating element. An alternative embodiment for the heating element 30 is illustrated in Figs. 8A - 8C. There, heating element 30a still includes legs 42 attached at either end of a rail 40. Instead of having a variable height, as illustrated in Figs. 7A - 7B, rail 40a has a variable width which increases to a maximum near the center and is a minimum at either end. The exact dimensions of the rail 40a will again depend on the length of the rail and on the anticipated operating temperature range of the heating element 30a.

The heating elements 30 will be formed from various high nickel steels, with 718 Inconel® being preferred.

Referring now to Fig. 9, the bonding apparatus 10 will be employed in a system 50 including a positioner 52 for supporting and reciprocating the bonding apparatus 10, a power supply 54 for supplying current to the L-shaped connectors 32, a temperature controller 56 for sensing the temperature of the heating elements 30 and adjusting the output of the power supply 54 to control the temperatures at a preselected level, and a master controller 58 for coordinating the actions of the positioner, temperature controller, and power supply. The bonding apparatus 10 is mounted to reciprocate above a conveyor 59 for feeding a continuous series of semiconductor dies 60 synchronously with a bonding tape 70. As illustrated, the system 50 is particularly intended for forming inner lead bonds where the leads on the bonding tape 70 are formed with the bonding pads on the semiconductor dies 60. The system, however, may be easily modified to accomodate the forming of outer lead bonds either to conventional lead frames or to other substrates, as is well known in the art.

Referring now to Figs. 10A - 10C, the method of the present invention will be described in detail. A semiconductor die 60 having a plurality of gold bonding pads 62 formed about its periphery is advanced beneath bonding tape 70. The tape 70 includes a plastic backing film 72 having tin-plated copper leads 74 formed on the lower surface thereof. The die 60 and film 74 advanced to a position beneath the bonding apparatus 10 so that the rows of bonding pads 62 are aligned directly beneath the linear heating elements 30. The inner ends of the leads 74 are also aligned between the heating elements 30 and the bonding pads 62. In the position shown in Fig. 10A, the heating elements are typically at a maintenance temperature of approximately 200°C.

Once all elements in the system have been properly aligned, the heating elements are raised to a desired temperature, typically in the range from 300°C to 305°C, selected to form the eutectic bond between the tin and gold. The temperature of the bonding elements 30 is sensed by a thermocouple 80 (Fig. 9) which feeds to the temperature controller 56. Once the desired bonding temperature has been reached, the bonding apparatus 10 is lowered by the positioner 52 so that the inner ends of the leads 74 are heated and contacted with the bonding pads 62. After a preselected time period, typically about 2 seconds, the tin and gold are melted to form the eutectic alloy, and the temperature of the heating elements 30 is lowered to the maintenance temperature. Once the elements have cooled, the bonding apparatus 10 is raised, and the semiconductor die 60 is attached to the bonding tape 70, as illustrated in Fig. 10C. The semiconductor die 60 may then be transported on the bonding tape for further processing, which may include the formation of outer lead bonds using the bonding apparatus 10 of the present invention.

Although the foregoing invention has been described in some detail by way of illustration and example for purposes of clarity of understanding, it will be obvious that certain changes and modifications may be practiced within the scope of the appended claims.

## Claims

1. A bonding apparatus (10) comprising:
an elongated core (14) composed of an electrically and thermally insulating material,
four electric power buses (20) arranged around said core (14) in a square array and mounted along said core (14),
means for connecting the positive pole of a power source to a first diagonally opposed pair of said buses (20a) and a negative pole thereof to a second diagonally opposed pair of said buses (20b), thereby defining positive buses (20a) and negatives buses (20b),
four linear resistance heating elements (30), each of said elements including a pair of electrically conductive legs (42) and a rail (40) extending between said legs (42), wherein one leg (42) of each pair is electrically connected to a positive bus (20a) and the other leg to a negative bus (20b), the lower end of each bus (20a, 20b) being connected to two elements (30), characterized in that said rail (40) has a variable cross-section area which is greatest at the middle of said rail (40) and continuously diminishes from the middle to said legs, such variable cross-section area providing substantially even heating along the entire length of each element (30) when current is applied.

2. A bonding apparatus (10) as in claim 1, wherein each pair of adjacent buses (20a, 20b) form a substantially flat continuous face with electrically isolated positive and negative regions.

3. A bonding apparatus (10) as in claim 2, wherein one of said elements (30) is secured to each flat face.

4. A bonding apparatus (10) as in claim 2, wherein each opposed pair of buses (20a, 20b) is electrically connected to a respective conductor of L-shaped cross-section (32a, 32b).

5. A system for tape bonding semiconductor dies (60), said system comprising:
means for conveying the semiconductor dies (60) along a path,
means for feeding metal bonding tape (70) proximate the semicondcutor dies (60),
a bonding apparatus (10) as defined in one of claims 1 to 4, wherein said power source (54) is adapted for feeding a regulated current to said elements (30),
a temperature controller (56) for sensing the temperatures of said elements (30) and regulating the current thereto, and
a positioner (52) for reciprocating the bonding apparatus so that said elements (30) press the bonding tape (70) against the semiconductor dies (60).

6. A system as in claim 5, wherein said elements (30) are composed of high nickel steel.

7. A method for tape bonding semiconductor dies (60), said method comprising:
transporting a plurality of semiconductor dies (60) along a path,
feeding metal bonding tape (70) proximate to the semiconductor dies (60),
pressing the tape (70) onto the dies (60) with a bonding apparatus (10) as defined in one of claims 1 through 4,
providing a current to the bonding apparatus (10) selected to heat said elements (30) to a first temperature selected to effect bonding prior to pressing the tape (70) with the bonding apparatus (10), and
stopping the current to the bonding apparatus (10) and allowing said elements (30) to cool to a second temperature prior to removing the bonding apparatus (10) from the tape (70).

8. A method as in claim 7, wherein the first temperature is sufficient to effect eutectic bonding of the metal bonding tape (70) to metal bonding pads on the semiconductor die (60).

9. A method as in claim 8, wherein the metal tape (70) is tin-plated copper, the bonding pads are gold, and the first temperature is in the range from about 300°C to 305°C.

## Patentansprüche

1. Eine Heftvorrichtung (10), umfassend:
einen langgestreckten Kern (14), bestehend aus einem elektrisch und thermisch isolierenden Material,
vier elektrischen Leistungsbussen (20), die rings um den Kern (14) in einem Rechteckmuster und längs des Kerns (14) montiert angeordnet sind,
Mittel für die Verbindung des positiven Poles einer Leistungsquelle mit einem ersten diagonal einander gegenüberliegenden Paar der Busse (20a) und eines negativen Pols derselben mit einem zweiten diagonal einander gegenüberliegenden Paar der Busse (20b), wodurch positive Busse (20a) und negative Busse (20b) definiert werden,
vier linearen Widerstandsheizelementen (30), wobei jedes der Elemente ein Paar von elektrisch leitenden Schenkeln (42) und eine Schiene (40) umfaßt, die sich zwischen den Schenkeln (42) erstreckt, wobei ein Schenkel (42) jedes Paare elektrisch mit einem positiven Bus (20a) und der andere Schenkel mit einem negativen Bus (20b) verbunden ist, wobei das untere Ende jedes Busses (20a, 20b) mit zwei Elementen (30) verbunden ist, dadurch gekennzeichnet, daß die Schiene (40) eine variable Querschnittsfläche aufweist, die am größten in der Mitte der Schiene (40) ist und kontinuierlich von der Mitte hin zu den Schenkeln abnimmt, welche variable Querschnittsfläche im wesentlichen gleichförmige Erhitzung längs der gesamten Länge jedes Elements (30) bei Anlegen von Strom herbeiführt.

2. Eine Heftvorrichtung (10) nach Anspruch 1, bei dem jedes Paar von benachbarten Bussen (20a, 20b) eine im wesentlichen flache, durchgehende Fläche mit elektrisch isolierten positiven und negativen Bereichen umfaßt.

3. Eine Heftvorrichtung (10) nach Anspruch 2, bei der eines der Elemente (30) mit jeder flachen Seite verbunden ist.

4. Eine Heftvorrichtung (10) nach Anspruch 2, bei der jedes einander gegenüberliegende Paar von Bussen (20a, 20b) elektrisch mit einem zugeordneten Leiter von L-förmigem Querschnitt (32a, 32b) verbunden ist.

5. Ein System für das Bandheften von Halbleiterchips (60), welches System umfaßt:
Mittel für das Fördern der Halbleiterchips (60) längs einer Strecke,
Mittel für das Zuführen von Metallheftband (70) nahe den Halbleiterchips (60),
eine Heftvorrichtung (10) nach einem der Ansprüche 1 bis 4, wobei die Leistungsquelle (54) ausgebildet ist zum Zuführen von geregeltem Strom zu den Elementen (30),
eine Temperatursteuerung (56) für das Erfassen der Temperaturen der Elemente (30) und Regeln des ihnen zugeführten Stromes, und
eine Positioniervorrichtung (52) für die Hin- und Herbewegung der Heftvorrichtung derart, daß die Elemente (30) das Heftband (70) gegen die Halbleiterchips (60) pressen.

6. Ein System nach Anspruch 5, bei dem die Elemente (30) aus einem hochnickelhaltigen Stahl bestehen.

7. Ein Verfahren für das Bandheften von Halbleiterchips (60), welches Verfahren umfaßt:
Transportieren einer Mehrzahl von Halbleiterchips (60) längs einer Strecke,
Zuführen von Metallheftband (70) in die Nähe der Halbleiterchips (60),
Pressen des Bandes (70) gegen die Chips (60) mit einer Heftvorrichtung (10) nach einem der Ansprüche 1 bis 4,
Zuführen eines Stromes zu der Heftvorrichtung (10), ausgewählt zum Erhitzen der Elemente (30) auf eine erste Temperatur, ausgewählt zum Bewirken des Heftens vor dem Anpressen des Bandes (70) mit der Heftvorrichtung (10) und
Beenden des Stromflusses zu der Heftvorrichtung (10) und Zulassen des Abkühlens der Elemente (30) auf eine zweite Temperatur, bevor die Heftvorrichtung (10) von dem Band (70) entfernt wird.

8. Ein Verfahren nach Anspruch 7, bei dem die erste Temperatur hinreicht zum Bewirken des eutektischen Heftens des Metallheftbandes (70) mit metallischen Heftnopppen auf dem Halbleiterchip (60).

9. Ein Verfahren nach Anspruch 8, bei dem das Metallband (70) zinnplattiertes Kupfer ist, die Heftnoppen aus Gold sind und die erste Temperatur im Bereich von etwa 300°C bis 305°C liegt.

## Revendications

1. Appareil de soudage (10) comprenant :
- un âme allongé (14) composé d'un matériau électriquement et thermiquement isolant,
- quatre barres d'alimentation électrique (20) disposées autour dudit âme (14) selon un arrangement carré et montées le long dudit âme (14),
- des moyens pour connecter le pôle positif d'une source d'énergie à une première paire (20a) diagonalement opposée desdites barres et un pôle négatif de ladite source d'énergie à une deuxième paire diagonalement opposée (20b) desdites barres, définissant ainsi des barres positives (20a) et des barres négatives (20b),
- quatre éléments de chauffage à résistance linéaire (30), chacun desdits éléments comprenant une paire de pieds électriquement conducteurs (42) et une traverse (40) s'étendant entre lesdits pieds (42), un des pieds (42) de chaque paire étant électriquement relié à une barre positive (20a) et l'autre pied étant relié à une barre négative (20b), l'extrémité inférieure de chaque barre (20a, 20b) étant reliée à deux éléments (30), caractérisé en ce que ladite traverse (40) a une section transversale variable qui est plus grande au milieu de ladite traverse (40) et qui diminue de façon continue à partir du milieu vers lesdits pieds, une telle section transversale variable fournissant un chauffage sensiblement égal sur toute la longueur de chaque élément (30) lorsque le courant est appliqué.

2. Appareil de soudage (10) selon la revendication 1, dans lequel chaque paire de barres adjacentes (20a, 20b) forme une face continue sensiblement plane avec des régions positives et négatives isolées électriquement.

3. Appareil de soudage (10) selon la revendication 2, dans lequel un desdits éléments (30) est fixé sur chaque face plane.

4. Appareil de soudage (10) selon la revendication 2, dans lequel chaque paire opposée de barres (20a, 20b) est électriquement reliée à un conducteur respectif dont la section transverse est en forme de L (32a, 32b).

5. Dispositif pour le soudage sur bandes de puces semiconductrices (60), ledit dispositif comprenant :
- des moyens pour transporter des puces semiconductrices (60) le long d'un chemin,
- des moyens pour fournir de la bande de soudage métallique au voisinage des puces semiconductrices (60),
- un appareil de soudage (10) selon l'une des revendications 1 à 4, dans lequel ladite source d'énergie (54) est prévue pour fournir un courant régulé auxdits éléments (30);
- une commande de température (56) pour capter les températures desdits éléments (30) et pour commander le courant vers ces éléments, et
- un positionneur (52) pour actionner d'un mouvement de va-et-vient l'appareil de soudage de manière à ce que lesdits éléments (30) compriment la bande de soudure (70) contre les puces semiconductrices (60).

6. Dispositif selon la revendication 5, dans lequel lesdits éléments (30) sont composés d'un acier à haute teneur en nickel.

7. Procédé pour la soudage par bande de puces semiconductrices (60), ledit procédé comprenant les étapes de :
- transporter une pluralité de puces semiconductrices (60) le long d'un chemin,
- fournir de la bande de soudage métallique (70) au voisinage des puces semiconductrices (60),
- comprimer la bande (70) contre les puces (60) avec un appareil de soudage (10) tel que défini dans l'une des revendications 1 à 4,
- fournir un courant à l'appareil de soudage (10) sélectionné pour chauffer lesdits éléments (30) jusqu'à une première température sélectionnée pour effectuer la soudure avant de comprimer la bande (70) avec l'appareil de soudage (10), et
- interrompre le courant vers l'appareil de soudage (10) et permettre auxdits éléments (30) de se refroidir jusqu'à une deuxième température avant d'enlever l'appareil de soudage (10) de la bande (70).

8. Procédé selon la revendication 7, dans lequel ladite première température est suffisante pour réaliser une fixation par eutectique de la bande métallique de soudage (70) contre une plage de connexion sur la puce semiconductrice (60).

9. Procédé selon la revendication (8), dans lequel la bande de métal (70) est du cuivre étamé, les plages de connexions sont de l'or, et la première température se situe dans la gamme de 300 à 305°C.
